# EUROPEAN PATENT APPLICATION

(11) **EP 4 726 082 A1**
(43) Date of publication of application: **15.04.2026**
(21) Application number: 24907612.6
(22) Date of filing: 16.04.2024
(51) Int. Cl.: C30B 25/18, C30B 29/46, H01L 21/02

(54) **HYPOTAXY METHOD USING TWO-DIMENSIONAL MATERIAL FOR FORMING CRYSTALLINE THIN FILM**

(30) Priority: 20.12.2023 KR 20230187156
(71) Applicant: Seoul National University R&DB Foundation, Seoul 08826 (KR)
(72) Inventor: MOON, Dong Hoon, Seoul 08785 (KR); LEE, Gwan Hyoung, Seoul 05268 (KR)
(74) Representative: Zenz Patentanwälte Partnerschaft mbB
(86) International application number: PCT/KR2024/005049
(87) International publication number: WO 2025/135318

(57) **Abstract**

The present disclosure relates to a method for forming a crystalline thin film, and more particularly, to a method capable of forming a defect-free single crystalline or polycrystalline thin film using a two-dimensional material template, regardless of the type of the lower substrate.

## Description

### 1. Field

The present disclosure relates to a method for forming a crystalline thin film, and more specifically, to a hypotaxy method capable of forming a defect-free single crystalline or polycrystalline thin film regardless of the type of the lower substrate.

The present disclosure claims the benefit of Korean Patent Application No. 10-2023-0187156 filed with the Korean Intellectual Property Office on December 20, 2023, the entire contents of which are incorporated herein by reference.

### 2. Background

Materials are classified as amorphous, single crystalline, and polycrystalline according to their crystal structure. Amorphous materials do not form a crystal structure and have many defects, which hinder the movement and control of carriers such as electrons or holes, resulting in deterioration of material properties. Polycrystals are made up of larger grains, but they have many grain boundaries, and thus have better device characteristics than amorphous ones, but still have limitations. On the other hand, single crystalline materials have one crystal structure throughout the entire crystal, so they do not contain grain boundaries and have excellent material characteristics. Therefore, they are essential in various fields, including the semiconductor industry.

On the other hand, epitaxy growth, a method for growing a single crystalline thin film on a substrate, has limitations regarding the type of substrate on which the crystal is grown because the thin film to be grown and the substrate must have similar crystal structures and lattice constants. In addition, the method for epitaxy growth of a single crystalline thin film on top of a single crystalline template has limitations such as defect formation due to large strain and damage to the grown thin film during the process of removing the template after thin film synthesis. In addition, there is a limitation that it is impossible to form a stacked structure device because polycrystalline or single crystalline thin film cannot be formed on a substrate with a different crystal structure or on an amorphous substrate.

### SUMMARY

The technical problem to be solved by the present disclosure is to provide a method for forming a single crystalline or polycrystalline thin film having excellent material properties even on an amorphous substrate that is not a single crystalline, where epitaxy is not possible.

However, the problem to be solved by the present disclosure is not limited to the problem mentioned above, and other problems not mentioned can be clearly understood by those skilled in the art from the following description.

One embodiment of the present disclosure provides a method for forming a crystalline thin film, the method including forming a raw material thin film on a substrate; forming a template including a crystalline two-dimensional material on an upper portion of the raw material thin film; and crystallizing the raw material thin film by heating the raw material thin film where the template is formed under an inert gas atmosphere to form a crystalline thin film, wherein the crystalline thin film is formed by hypotaxy growth from a lower portion of the template.

The method for forming a crystalline thin film according to one embodiment of the present disclosure may form a defect-free single crystalline thin film even on a substrate that is not single crystalline.

The method for forming a crystalline thin film according to one embodiment of the present disclosure may form a polycrystalline thin film having the same microstructure along the microstructure of the two-dimensional material template, thereby enabling precise control over the crystal orientation and microstructure of the thin film to be formed.

The method for forming a crystalline thin film according to one embodiment of the present disclosure may allow the template to be naturally removed during the process of forming the crystalline thin film, and thus may not require an additional process for removing the template.

The method for forming a crystalline thin film according to one embodiment of the present disclosure may precisely control the number of layers of the crystalline thin film to be formed.

The effects of the present disclosure are not limited to the effects described above, and effects not mentioned can be clearly understood by those skilled in the art from the specification and the attached drawings.

### BRIEF DESCRIPTION OF THE DRAWINGS

FIG. 1 is a schematic view illustrating (a) a state in which a transition metal dichalcogenide (TMD) is epitaxially grown on a crystalline substrate and (b) a state in which a crystalline thin film is hypotaxially grown from a lower portion of a template according to one embodiment of the present disclosure.
FIG. 2 is a view sequentially illustrating each step of a method for forming a crystalline thin film according to one embodiment of the present disclosure, which is performed while a reaction gas is being supplied.
FIG. 3 is a schematic view illustrating a nucleus formed in a defect part of a template.
FIG. 4 shows TEM images of (a) a single crystalline graphene synthesized in Manufacturing Example 1, (b) single crystalline graphene of Manufacturing Example 1 supplied with hydrogen sulfide for 30 minutes, and (c) single crystalline graphene of Manufacturing Example 1 treated with O₂ plasma.
FIG. 5 shows (a) SEM images, (b) TEM images, (c) diffraction patterns, and (d) side surface TEM images of the surface of a MoS₂ thin film obtained in Experimental Example 1.
FIG. 6 shows optical microscope images by the number of MoS₂ single crystalline layers in the obtained thin film depending on the thickness of the molybdenum metal thin film being deposited.
FIG. 7a is a graph showing the relationship between the thickness of the molybdenum metal thin film being deposited and the number of MoS₂ single crystalline layers in the obtained thin film.
FIG. 7b is a Raman spectrum for MoS₂ single crystalline thin films having 1 to 4 layers.
FIG. 7c shows side surface TEM images of MoS₂ single crystalline thin films having 1 to 4, 6, 8, 14, and 99 layers.
FIG. 8 shows a Raman spectrum for WS₂, MoSe₂, and WSe₂ thin films obtained in Examples 2 to 4.
FIG. 9 shows TEM images and EDS analysis images for the surface (a) and side surface (b) of WS₂, MoSe₂, and WSe₂ thin films obtained in Examples 2 to 4.
FIG. 10 shows TEM images and diffraction patterns of the side surfaces of Mo, W, and MoO₂ thin films obtained in Examples 5 to 7.
FIG. 11 shows (a) Raman spectrum results, (b) a side surface TEM image, and (c) a diffraction pattern of MoS₂ thin films obtained in Example 8.
FIG. 12 shows (a) a side surface TEM image, (b) a top view of the TEM image and diffraction pattern, and (c) Raman spectrum results of the WS₂ thin film obtained in Example 9.
FIG. 13 shows (a) a schematic illustration of an intermediate stage of thin film formation in Example 10 using a polycrystalline graphene as a template, (b) a TEM image and diffraction pattern of the obtained MoS₂ thin film, (d) a DF-TEM image of the obtained MoS₂ thin film, and (c) a DF-TEM image of the polycrystalline graphene template.
FIG. 14 shows (a) optical microscope images for the WSe₂ thin film obtained in Example 12 and the polycrystalline graphene directly grown on a tungsten substrate, and (b) a Raman spectrum for the MoS₂ and WSe₂ thin films obtained in Examples 11 and 12.
FIG. 15 shows (a) a TEM image of a template in which a defect part was formed in advance in Example 13, and (b) a TEM image, (c) a diffraction pattern, and (d) a Raman spectrum of the obtained MoS₂ single crystalline thin film.
FIG. 16 shows a TEM image and a diffraction pattern for each of the MoS₂ thin films obtained in Examples 14 to 16.
FIG. 17 shows the horizontal and vertical direction thermal characteristics of the MoS₂ thin film obtained in Example 1.
FIG. 18 shows (a) an optical microscope and SEM image, (b) a transfer curve (or output curve), and (c) a transfer curve (or output curve) as a function of drain voltage of a field effect transistor (FET) device array manufactured using the MoS₂ thin film obtained in Example 1 as a channel.

### DETAILED DESCRIPTION

Throughout this specification, when a part is said to "include" or "comprise" a component, this does not mean excluding other components, but rather including other components, unless otherwise specifically stated.

Throughout this specification, when a component is said to be "on" another component, this includes not only cases where a component is in contact with another component, but also cases where another component exists between the two components.

Throughout this specification, the unit "parts by weight" may mean the weight ratio between each component.

Throughout this specification, "A and/or B" means "A and B, or A or B."

Throughout this specification, the word "hypotaxy" is a compound word of hypo, meaning "below", and taxy, meaning "alignment", and means a state of alignment in a direction below the template according to the crystal structure of the template.

Hereinafter, the present disclosure will be described in more detail.

One embodiment of the present disclosure includes forming a raw material thin film on a substrate; forming a template including a crystalline two-dimensional material on an upper portion of the raw material thin film; and crystallizing the raw material thin film by heating the raw material thin film where the template is formed under an inert gas atmosphere to form a crystalline thin film, wherein the crystalline thin film is formed by hypotaxy growth from a lower portion of the template.

The method for forming a crystalline thin film according to one embodiment of the present disclosure may allow the template to be naturally removed during the process of forming the crystalline thin film, and thus may not require an additional process for removing the template, and may precisely control the number of layers of the crystalline thin film to be formed.

The method for forming a crystalline thin film according to one embodiment of the present disclosure may form a defect-free single crystalline thin film even on a substrate other than a single crystalline, and is applicable to various processes and substrates since it is not limited by the type of substrate.

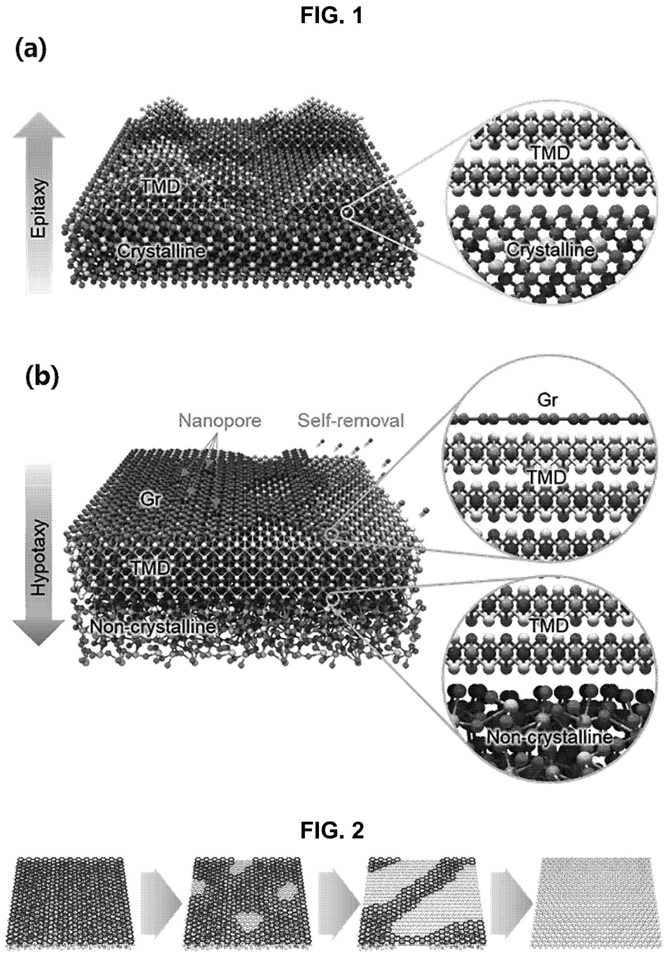

FIG. 1 is a schematic view illustrating (a) a state in which a transition metal dichalcogenide (TMD) is epitaxially grown on a crystalline substrate and (b) a state in which the crystalline thin film is hypotaxially grown from a lower portion of a template according to one embodiment of the present disclosure.

Referring to FIG. 1, unlike the conventional epitaxial growth method that requires the substrate under the thin film to be crystalline, particularly a single crystalline, the method for forming a crystalline thin film according to one embodiment of the present disclosure may form a defect-free single crystalline or polycrystalline thin film regardless of the type of substrate by hypotaxially growing from a lower portion of the template.

According to one embodiment of the present disclosure, the material included in the crystalline thin film to be formed may be applied without particular limitation as long as it is a material capable of having crystallinity. Specifically, the crystalline thin film may include a polymer, a metal, a ceramic, or a combination thereof, and more specifically, may include a transition metal, a transition metal chalcogen compound, or a transition metal oxide.

According to one embodiment of the present disclosure, the transition metal may include Sc, Ti, V, Cr, Mn, Fe, Co, Ni, Cu, Zn, Y, Zr, Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn, or alloys thereof.

According to one embodiment of the present disclosure, the transition metal chalcogen compound may be a transition metal dichalcogenide represented by the chemical formula MX₂ (M: transition metal, X: chalcogen element). For example, the transition metal dichalcogenide may be MoS₂, MoSe₂, MoTe₂, WS₂, WSe₂, or WTe₂, but is not necessarily limited thereto.

According to one embodiment of the present disclosure, the transition metal oxide may be MoO₂, WO₃, Sc₂O₃, TiO₂, V₂O₅, Cr₂O₃, Mn₃O₄, Fe₃O₄, Co₃O₄, NiO, or CuO, but is not necessarily limited thereto.

According to one embodiment of the present disclosure, the substrate may be a single crystalline, polycrystalline, or amorphous, and the material or crystal structure of the substrate may be used without any particular limitation.

According to one embodiment of the present disclosure, the raw material thin film may include a material to be formed as the crystalline thin film or may include a reactant of the crystalline thin film.

For example, when forming a crystalline thin film including a transition metal, the raw material thin film may include the transition metal, and when forming a crystalline thin film including a transition metal chalcogen compound, the raw material thin film may include a transition metal that is a reactant of the transition metal chalcogen compound.

According to one embodiment of the present disclosure, the step of forming the raw material thin film may be performed by physical vapor deposition (PVD), thermal evaporation, electron beam evaporation, sputtering, chemical vapor deposition (CVD), or atomic layer deposition (ALD), but is not necessarily limited thereto.

The thickness of the formed raw material thin film may be adjusted according to the desired thickness of the crystalline thin film to be formed.

According to one embodiment of the present disclosure, the crystalline two-dimensional material may include graphene, hexagonal boron nitride (hBN), transition metal chalcogen compound, graphene oxide, two-dimensional oxide, black phosphorus, phosphorene, or a combination thereof.

According to one embodiment of the present disclosure, the template may be one that is directly grown on the raw material thin film or one that is transferred onto the raw material thin film.

According to one embodiment of the present disclosure, the template may be directly grown on the raw material thin film by physical vapor deposition (PVD), thermal evaporation, electron beam evaporation, sputtering, chemical vapor deposition (CVD), or atomic layer deposition (ALD), etc., or may be grown on another substrate and then transferred onto the above-mentioned raw material thin film.

According to one embodiment of the present disclosure, the crystalline two-dimensional material may be polycrystalline or single crystalline.

Specifically, when the template includes a single crystalline two-dimensional material, the crystalline thin film being formed may be a single crystalline thin film aligned along the crystal direction of the single crystalline two-dimensional material. Alternatively, when the template includes a polycrystalline two-dimensional material, the crystalline thin film being formed may be a polycrystalline thin film having the same microstructure along the microstructure of the polycrystalline two-dimensional material.

The method for forming a crystalline thin film according to one embodiment of the present disclosure may form a polycrystalline thin film having the same microstructure along the microstructure of the two-dimensional template, and thus the crystal direction and microstructure of the thin film to be formed may be precisely controlled.

Hereinafter, the step of crystallizing the raw material thin film by heating the raw material thin film on which the template is formed under an inert gas atmosphere thereby forming a crystalline thin film will be described in more detail.

According to one embodiment of the present disclosure, the raw material thin film may be converted into a crystalline thin film by hypotaxial growth in the step of forming the crystalline thin film.

In the step of crystallizing the raw material thin film to form a crystalline thin film, the raw material thin film may be converted into a crystalline thin film by being heated under an inert gas atmosphere, thereby being recrystallized along the crystal structure of a lower portion of the template without going through a chemical reaction. Alternatively, the raw material thin film may be heated under an inert gas atmosphere as a reaction gas is being supplied and may be converted into a crystalline thin film having the same crystal structure as the crystal structure of the lower portion of the template, through a chemical reaction between the raw material thin film and the reaction gas.

According to one embodiment of the present disclosure, in the case of forming a crystalline thin film including a transition metal, the raw material thin film may include the transition metal, and by heating the raw material thin film on which the template is formed under an inert gas atmosphere, the raw material thin film may be converted into a crystalline thin film having the same crystal structure as the crystal structure of the template without going through a chemical reaction.

According to one embodiment of the present disclosure, the step of forming the crystalline thin film may be performed while a reaction gas is being supplied.

According to one embodiment of the present disclosure, in the case of forming a crystalline thin film including a transition metal chalcogen compound, the raw material thin film may include a transition metal, and the reaction gas may be a gas including a chalcogen element.

According to one embodiment of the present disclosure, in the case of forming a crystalline thin film including a transition metal oxide, the raw material thin film may include a transition metal, and the reaction gas may be a gas including an oxygen element.

According to one embodiment of the present disclosure, the template may have a defect part formed therein. The defect part may be a pore or a nanohole, and may preferably have a size of 10 nm or less.

According to one embodiment of the present disclosure, the defect part may be formed during or before the step of forming the crystalline thin film.

According to one embodiment of the present disclosure, by heating the raw material thin film on which the template is formed at a high temperature under an inert gas atmosphere, a defect part may be formed in the template during the step of forming the crystalline thin film. The heating temperature for forming the defect part during the step of forming the crystalline thin film may vary depending on the type of the two-dimensional material included in the template. For example, if the template includes graphene, 800° C or higher may be preferable.

According to one embodiment of the present disclosure, the method for forming the defect part prior to the step of forming the crystalline thin film may be by plasma treatment or high-temperature gas supply, but is not necessarily limited thereto.

FIG. 2 is a view sequentially illustrating each step of the method for forming a crystalline thin film according to one embodiment of the present disclosure, which is performed while the reaction gas is being supplied.

Referring to FIG. 2, the mechanism of the method for forming a crystalline thin film according to one embodiment of the present disclosure being performed while a reaction gas is being supplied will be described in detail.

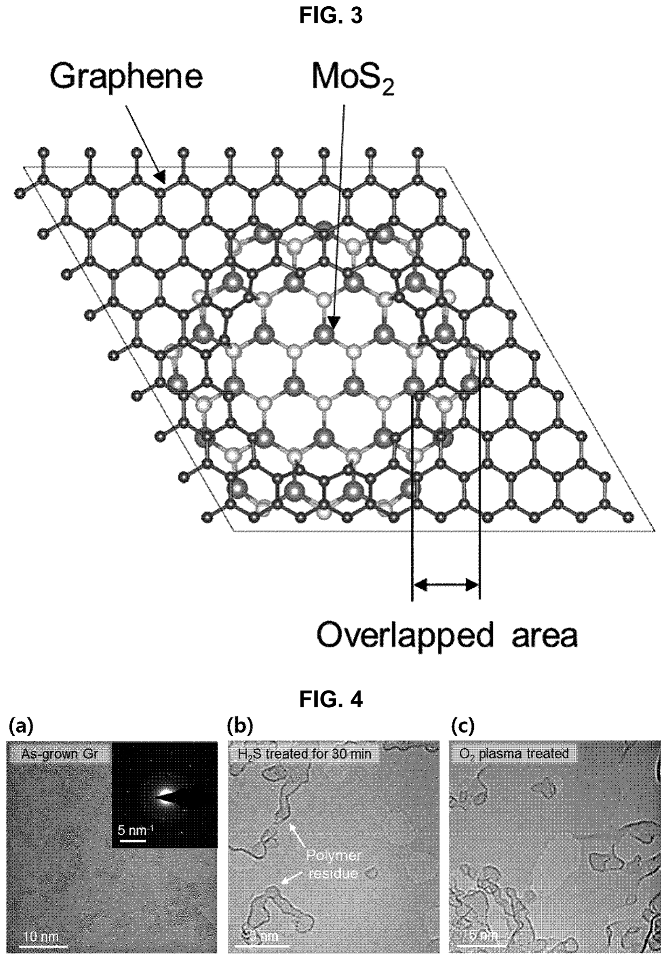

When a raw material thin film on which a template including a defect part is formed is heated while a reaction gas is being supplied under an inert gas atmosphere, the reaction gas may pass through the defect part and react with the raw material thin film to form a nucleus of several nanometers in size. FIG. 3 is a schematic view illustrating the nucleus formed in the defect part of the template. The nucleus is first formed on the lower portion of the template (overlapped area) at the edge of the defect part, and may be aligned in the same direction as the crystal direction of the template, and may grow while maintaining the crystal structure in the horizontal direction to the center of the defect part (basal plane) as the reaction gas is continuously supplied. As the reaction gas is continuously supplied, the defect part expands, and the nucleation and growth process may occur at the new edges. At this stage, each of the nuclei formed in the multiple defect parts may all be aligned in the same crystal direction as the template, and thus the obtained crystalline layer may be aligned in the same crystal direction as the template. In addition, as the reaction gas is continuously supplied, growth also occurs in the downward direction of the formed crystalline layer, either simultaneously or subsequent to the formation of the crystalline layer in contact with the lower portion of the template as mentioned above, and ultimately, a multilayer crystalline thin film aligned in the same crystal direction as the template may be formed.

According to one embodiment of the present disclosure, when the template is a single crystalline two-dimensional material, a single crystalline thin film without a crystal grain boundary is formed, and when the template is a polycrystalline two-dimensional material, a polycrystalline thin film having the same microstructure as the microstructure of the polycrystalline two-dimensional material may be formed.

According to one embodiment of the present disclosure, the template may be naturally removed by the step of crystallizing the raw material thin film by heating the raw material thin film where the template is formed under an inert gas atmosphere to form a crystalline thin film.

The method for forming a crystalline thin film according to one embodiment of the present disclosure may allow precise control the number of layers of the single crystalline thin film to be formed.

More specifically, precise control over the number of layers of the single crystalline thin film to be formed may be achieved by adjusting the thickness of the raw material thin film in consideration of the interlayer distance and the number of layers of the single crystalline material to be formed.

According to one embodiment of the present disclosure, the step of forming the crystalline thin film may be performed at a temperature of 150° C to 1,000° C. For example, the step of forming the crystalline thin film may be performed at a temperature of 150° C to 1,000° C, 300° C to 1,000° C, 500° C to 1,000° C, 700° C to 1,000° C, 800° C to 1,000° C, 900° C to 1,000° C, 150° C to 800° C, 300° C to 800° C, 500° C to 800° C, 150° C to 500° C or 300° C to 500° C. The temperature of the step of forming the crystalline thin film may be appropriately adjusted depending on the type of the reaction gas and whether or not to pre-form the defect part.

Since the step of forming the crystalline thin film is performed at a temperature of 800° C to 1,000° C, or 900° C to 1,000° C, a defect part may be formed during the step of forming the crystalline thin film.

If the defect part is pre-formed prior to the step of forming the crystalline thin film, the step of forming the crystalline thin film may be performed at a temperature of 150° C to 800° C, 300° C to 800° C, 500° C to 800° C, 150° C to 500° C or 300 ° C to 500 ° C.

Hereinafter, in order to specifically explain the present disclosure, embodiments will be described in detail. However, the embodiments according to the present disclosure may be modified in various different forms, and the scope of the present disclosure is not construed as being limited to the embodiments described below. The embodiments of this specification are provided to further completely explain the present disclosure to a person having average knowledge in the related art.

### Manufacturing Example 1. Synthesis of single crystalline graphene template

Single crystalline graphene was synthesized using a chemical vapor deposition method (CVD). Specifically, methane (CH₄) and hydrogen (H₂) gases were supplied onto a single crystalline copper foil, heated, and reacted for about 30 minutes, to synthesize a single crystalline graphene template.

### Manufacturing Example 2. Synthesis of polycrystalline graphene template

Polycrystalline graphene was synthesized using a chemical vapor deposition method (CVD). Specifically, methane (CH₄) and hydrogen (H₂) gases were supplied onto a polycrystalline copper foil, heated, and reacted for about 30 minutes, to synthesize a polycrystalline graphene template.

### <Experimental Example 1. Confirmation of defect part formation in single crystalline graphene template>

After the single crystalline graphene synthesized in Manufacturing Example 1 was positioned on top of a substrate using a wet transfer method or a dry transfer method, hydrogen sulfide (H₂S) gas was supplied at a flow rate of 20 sccm at a temperature of 1,000°C for 30 minutes on the single crystalline graphene. Thereafter, a TEM image was obtained for the single crystalline graphene treated with the hydrogen sulfide gas using a transmission electron microscope.

For the single crystalline graphene synthesized in Manufacturing Example 1, an O₂ plasma treatment device (Femto CUTE) was used to perform O₂ plasma treatment at a power of 60 W under an O₂ 20 sccm atmosphere, and a TEM image was obtained for the single crystalline graphene of Manufacturing Example 1 treated with oxygen plasma.

FIG. 4 shows TEM images of (a) the single crystalline graphene synthesized in Manufacturing Example 1, (b) single crystalline graphene of Manufacturing Example 1 supplied with hydrogen sulfide for 30 minutes, and (c) single crystalline graphene of Manufacturing Example 1 treated with O₂ plasma.

Referring to FIG. 4, it can be confirmed that the single crystalline graphene synthesized in Manufacturing Example 1 does not contain a defect part, but that the single crystalline graphene supplied with hydrogen sulfide at about 1,000°C for 30 minutes and the single crystalline graphene treated with O₂ plasma contain vacancy defects.

### Example 1. Formation of molybdenum disulfide (MoS₂) single crystalline thin film

A silicon substrate on which an oxide film (thickness: 285 nm) was formed was used as a substrate. The single crystalline graphene synthesized in Manufacturing Example 1 was prepared as a template including a crystalline two-dimensional material. Hydrogen sulfide (H₂S) gas was used as a reaction gas for supplying sulfur.

First, a molybdenum (Mo) metal thin film was deposited as a raw material thin film on the substrate using electron beam vacuum deposition. Herein, the thickness of the deposited molybdenum metal thin film was adjusted to 0.3 nm to 40 nm depending on the thickness of the desired MoS₂ thin film.

Then, the single crystalline graphene was transferred onto the molybdenum metal thin film using a dry transfer method.

After placing the substrate, on which the template and the raw material thin film were formed, in a reaction chamber, the pressure of the reaction chamber was adjusted to satisfy 10⁻³ Torr to 760 Torr (atmospheric pressure). In order to form the thin film, the temperature of the reaction chamber was raised to 1,000°C at a rate of 15°C/min, and then the reaction was proceeded while supplying argon (Ar) gas and hydrogen sulfide (H₂S) gas at flow rates of 130 and 20 sccm, respectively.

Upon completion of the reaction after about 120 minutes, the MoS₂ single crystalline thin film formed on the substrate was obtained.

### <Experimental Example 2. Observation of MoS₂ growth over time and confirmation of thin film single crystallinity>

In order to observe the MoS₂ formation process of Experimental Example 1 per different growth time and to confirm whether the formed thin film has single crystallinity, SEM images, TEM images, and diffraction patterns were taken for each MoS₂ formed when the reaction was conducted for 30, 60, 90, and 120 minutes while supplying the reaction gas, using a scanning electron microscope and a transmission electron microscope.

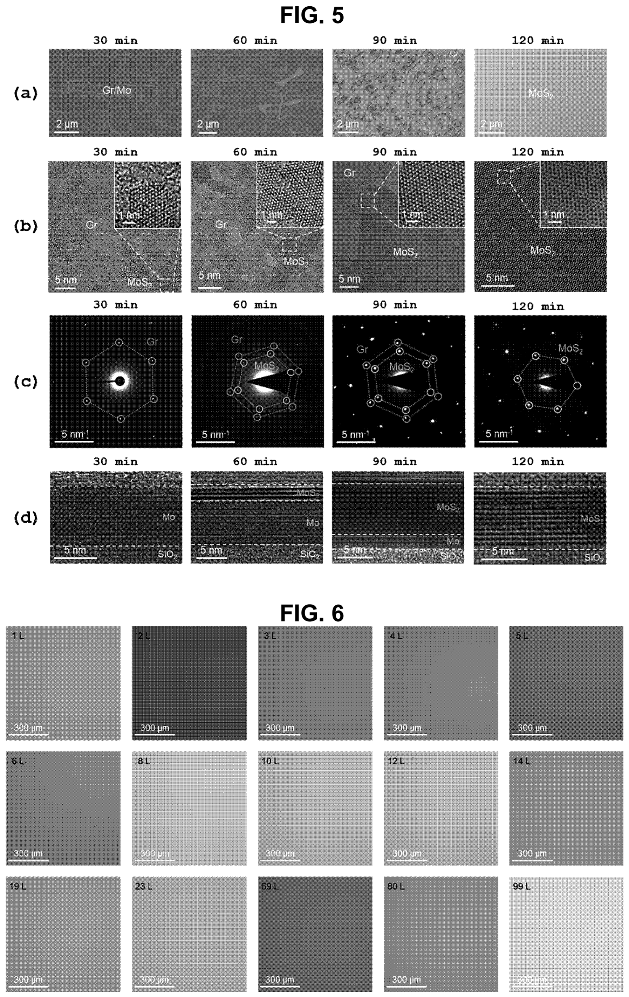

FIG. 5 shows (a) SEM images, (b) TEM images, (c) diffraction patterns, and (d) side surface TEM images of the surface of the MoS₂ thin film obtained in Experimental Example 1.

Referring to FIG. 5, since the graphene template was not completely removed during the intermediate process of MoS₂ formation, a part of the graphene template could be observed on the sample surface, and it was confirmed that all the formed MoS₂ nuclei had a crystal direction that matched the graphene template and had a defect-free single crystalline structure. In addition, it was confirmed through the side TEM image that the MoS₂ thin film formed had a complete layered structure and that the growth of the MoS₂ layer occurred in a horizontal direction from the formed nucleus.

Furthermore, referring to FIG. 5, the side surface TEM image of a sample at an intermediate stage of MoS₂ formation confirmed that a portion of the molybdenum metal thin film was converted into a MoS₂ single crystalline layer, and that a unconverted molybdenum metal layer existed under the formed MoS₂ single crystalline layer. This suggests that since hypotaxis growth initiates from the lower portion of the template and the single crystalline layer is formed in sequence in the direction of the substrate by the hypotaxial growth, the method for forming a single crystalline thin film according to the present disclosure may be applied regardless of the substrate.

Additionally, referring to FIG. 5, it was confirmed that the template was naturally removed during the reaction process, as there was no graphene template existing on the MoS₂ thin film obtained after a 120-minute reaction, despite the absence of any additional process for removing the graphene template in Example 1.

### <Experimental Example 3. Confirmation of single crystalline layer growth according to thickness of raw material thin film>

In Example 1, the number of MoS₂ single crystalline layers was investigated from the obtained thin films by controlling the thickness of the molybdenum metal thin film being deposited as the raw material thin film, to 0.3 nm to 40 nm.

Specifically, the thickness of the molybdenum metal thin film was controlled to 0.3 nm, 0.5 nm, 0.8 nm, 1.2 nm, 1.5 nm, 2 nm, 2.5 nm, 3 nm, 4.5 nm, 6 nm, 7.5 nm, 15 nm, 25 nm, and 40 nm, and TEM images were taken using a transmission electron microscope for each MoS₂ single crystalline thin film formed, and the number of layers was calculated, and Raman spectrum analysis was performed.

The number of layers of each MoS₂ single crystalline thin film formed by controlling the thickness of the molybdenum metal thin film to 0.3 nm, 0.5 nm, 0.8 nm, 1.2 nm, 1.5 nm, 2 nm, 2.5 nm, 3 nm, 4.5 nm, 6 nm, 7.5 nm, 15 nm, 25 nm, and 40 nm were 1, 2, 3, 4, 5, 6, 8, 10, 12, 14, 19, 23, 69, 80, and 99, respectively.

FIG. 6 shows optical microscope images by the number of MoS₂ single crystalline layers in the obtained thin film depending on the thickness of the molybdenum metal thin film being deposited.

Referring to FIG. 6, it was confirmed that the formed MoS₂ single crystalline thin film had a very uniform thin film surface regardless of the number of layers.

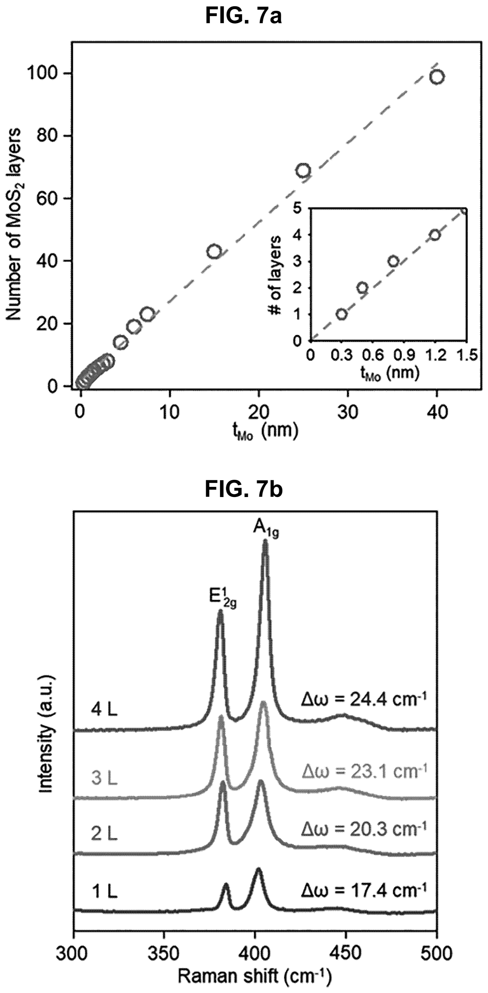

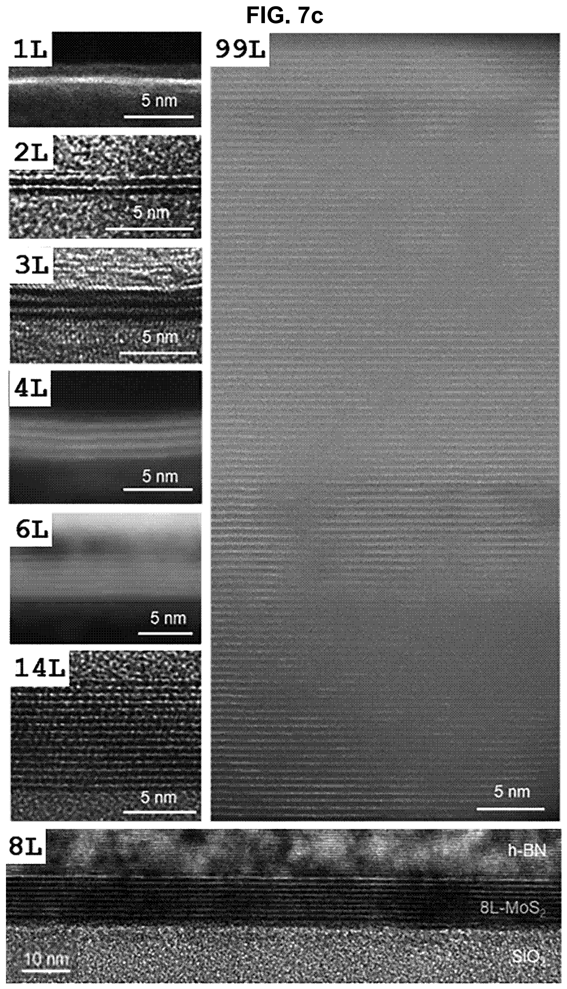

FIG. 7a is a graph showing the relationship between the thickness of the deposited molybdenum metal thin film and the number of MoS₂ single crystalline layers in the obtained thin film. FIG. 7b is a Raman spectrum for MoS₂ single crystalline thin films having 1 to 4 layers. FIG. 7c is a side surface TEM image of MoS₂ single crystalline thin films having 1 to 4, 6, 8, 14, and 99 layers.

Referring to FIGs. 7a to 7c, it was confirmed that the number of layers of the crystalline thin film being manufactured may be precisely controlled by adjusting the thickness of the raw material thin film, and it was also confirmed that, as the number of layers increased from 1 to 4, the distance between two peaks (E¹_{2g}, A_{1g}) in the Raman spectrum of the manufactured MoS₂ single crystalline thin films increased.

As a result of analyzing the Raman spectrum, it was confirmed that the position of the peak no longer changed when the number of layers was 5 or more.

### Example 2. Formation of tungsten disulfide (WS₂) single crystalline thin film

Except for depositing a tungsten (W) metal thin film with a thickness of 40 nm as the raw material thin film, a tungsten disulfide single crystalline thin film was formed in the same manner as in Example 1.

### Example 3. Formation of molybdenum diselenide (MoSe₂) single crystalline thin film

A molybdenum (Mo) metal thin film was deposited with a thickness of 10 nm as a raw material thin film, and a molybdenum diselenide single crystalline thin film was formed in the same manner as in Example 1, except that, selenium gas, which was vaporized selenium (Se) powder (purchased from Alfa Aesar, 100 mg), and hydrogen (H₂) gas were supplied at a flow rate of 5 sccm each for 6 hours, instead of supplying hydrogen sulfide (H₂S) gas.

### Example 4. Formation of tungsten diselenide (WSe₂)single crystalline thin film

A tungsten (W) metal thin film with a thickness of 30 nm was deposited as the raw material thin film, and a tungsten diselenide single crystalline thin film was formed in the same manner as in Example 1, except that, selenium gas, which was vaporized selenium (Se) powder (purchased from Alfa Aesar, 100 mg), and hydrogen (H₂) gas were supplied at a flow rate of 5 sccm each for 9 hours, instead of supplying hydrogen sulfide (H₂S) gas.

### Example 5. Formation of Molybdenum (Mo) single crystalline thin film

A molybdenum (Mo) metal thin film with a thickness of 5 nm was deposited as the raw material thin film, and a molybdenum single crystalline thin film was formed in the same manner as in Example 1, except that hydrogen sulfide (H₂S) gas was not supplied.

### Example 6. Formation of Tungsten (W) single crystalline thin film

A tungsten (W) metal thin film with a thickness of 10 nm was deposited as the raw material thin film, and a tungsten single crystalline thin film was formed in the same manner as in Example 1, except that hydrogen sulfide (H₂S) gas was not supplied.

### Example 7. Formation of Molybdenum Dioxide (MoO₂) single crystalline thin Film

A molybdenum (Mo) thin film with a thickness of 10 nm was deposited as the raw material thin film, and a molybdenum dioxide single crystalline thin film was formed in the same manner as in Example 1, except that oxygen (O₂) gas was supplied at a flow rate of 10 sccm each for 4 hours instead of supplying hydrogen sulfide (H₂S) gas.

### <Experimental Example 4. Confirmation of single crystallinity of WS₂, MoSe₂, WSe₂, Mo, W, and MoO₂ thin films>

To confirm the single crystallinity of WS₂, MoSe₂, and WSe₂ thin films obtained in each of Examples 2 to 4, Raman spectroscopy, energy dispersive spectroscopy (EDS), and TEM image analysis were performed on the obtained thin films.

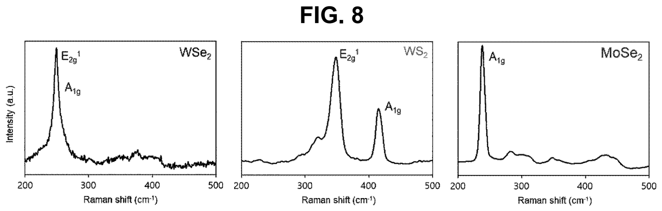

FIG. 8 shows the Raman spectrum for WS₂, MoSe₂, and WSe₂ thin films obtained in Examples 2 to 4.

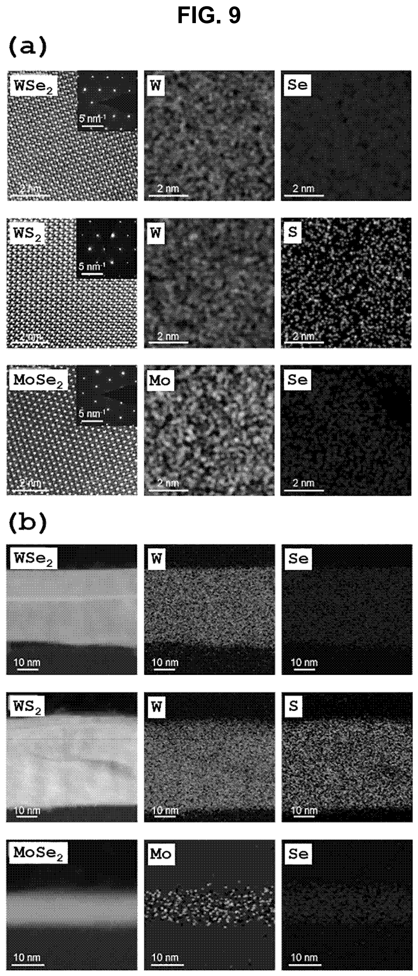

FIG. 9 shows TEM images and EDS analysis images of the surface of WS₂, MoSe₂, and WSe₂ thin films obtained in Examples 2 to 4.

Referring to FIGs. 8 and 9, it was confirmed that the WS₂, MoSe₂, and WSe₂ crystals formed by the method according to the present disclosure exhibit high crystallinity, and that their constituent elements are uniformly distributed.

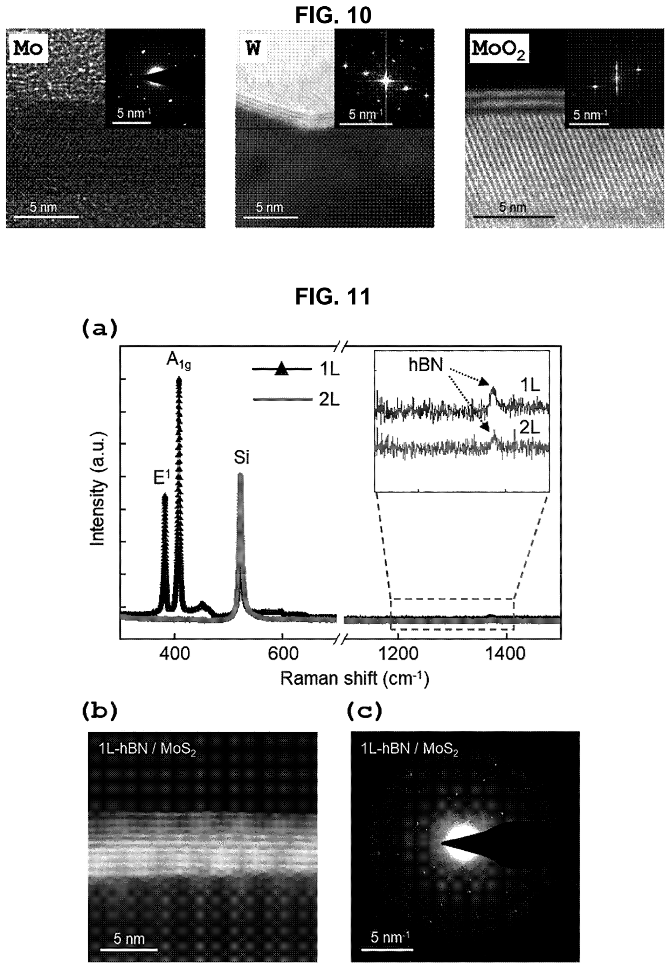

FIG. 10 shows TEM images and diffraction patterns of the side surfaces of Mo, W, and MoO₂ thin films obtained in Examples 5 to 7.

Referring to FIG. 10, it was confirmed that the Mo, W, and MoO₂ thin films formed by the method according to the present disclosure were well-formed as single crystalline, and that the method for forming a single crystalline thin film according to the present disclosure may be universally applied not only to transition metal chalcogen compounds, but also to various other materials for the formation of single crystalline thin films.

### Example 8. Formation of MoS₂ single crystalline thin film using hexagonal boron nitride

A MoS₂ single crystalline thin film was formed in the same manner as in Example 1, except that a monolayer hexagonal boron nitride (1L-hBN) was used as the template. The monolayer hexagonal boron nitride was obtained by exfoliating from a boron nitride crystal (Kenji Watanabe, Takashi Taniguchi).

### Example 9. Formation of WS₂ single crystalline thin film using single crystalline tungsten disulfide

WS₂ single crystalline thin film was formed in the same manner as in Example 1, except that a bilayer single crystalline tungsten disulfide (2L-WS₂) was used as the template, and a tungsten (W) metal thin film with a thickness of 40 nm was deposited. The bilayer single crystalline tungsten disulfide (2L-WS₂) used as the template was grown as single crystalline on a silicon substrate where the oxide layer (thickness: 285 nm) was formed, by physical vapor deposition (PVD) using WS₂ powder (Alfa Aesar, LOT: M11F022) at approximately 1000 °C for 1 hour under an argon (Ar) gas atmosphere (300 sccm).

### Example 10. Formation of MoS₂ polycrystalline thin film using polycrystalline graphene

MoS₂ polycrystalline thin film was formed in the same manner as in Example 1, except that polycrystalline graphene synthesized in Manufacturing Example 2 was used as the template.

### Example 11. Formation of MoS₂ polycrystalline thin film using polycrystalline graphene directly grown on substrate

MoS₂ polycrystalline thin film was formed in the same manner as in Example 1, except that, polycrystalline graphene was directly grown as the template by supplying methane (CH₄) and hydrogen (H₂) gases and heating and reacting for approximately 30 minutes on the deposited molybdenum raw material thin film using chemical vapor deposition method.

### Example 12. Formation of WSe₂ polycrystalline thin film using polycrystalline graphene directly grown on substrate

WSe₂ polycrystalline thin film was formed in the same manner as in Example 4, except that, polycrystalline graphene was directly grown as the template by supplying methane (CH₄) and hydrogen (H₂) gases and heating and reacting for approximately 30 minutes on the deposited tungsten raw material thin film using chemical vapor deposition method.

### <Experimental Example 7. Observation according to type of two-dimensional material template>

Analyses of Raman spectrum results, TEM images, and diffraction pattern were performed on the thin films obtained in Examples 8 to 12.

In addition, in order to confirm whether the polycrystalline microstructure is similarly realized in the thin film when the polycrystalline two-dimensional material is used as a template, dark-field transmission electron microscopy (DF-TEM) images were obtained for the MoS₂ polycrystalline thin film obtained in Example 10 and the polycrystalline graphene template used therein.

FIG. 11 shows (a) Raman spectroscopy results, (b) a side-surface TEM image, and (c) diffraction pattern of MoS₂ thin films obtained in Example 8.

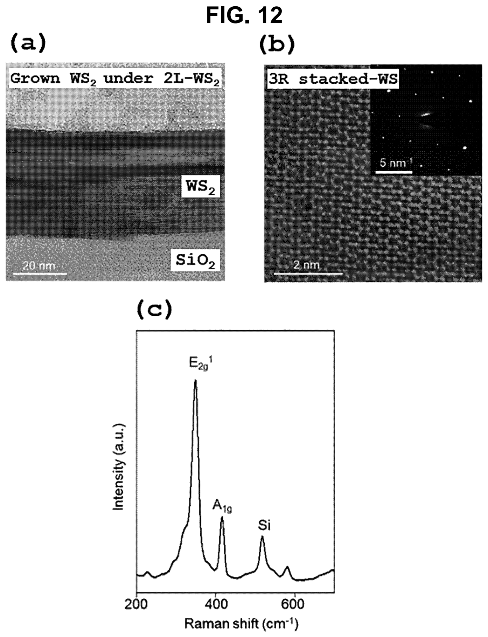

FIG. 12 shows (a) a side surface TEM image, (b) a top view of the TEM image and diffraction pattern, and (c) Raman spectrum results of the WS₂ thin film obtained in Example 9.

Referring to FIGs. 11 and 12, it was confirmed that the MoS₂ thin film and WS₂ thin film obtained using monolayer hexagonal boron nitride (1L-hBN) or bilayer single crystalline tungsten disulfide (2L-WS₂) as templates exhibit defect-free single crystalline structures and form intact layered structures without vertical growth.

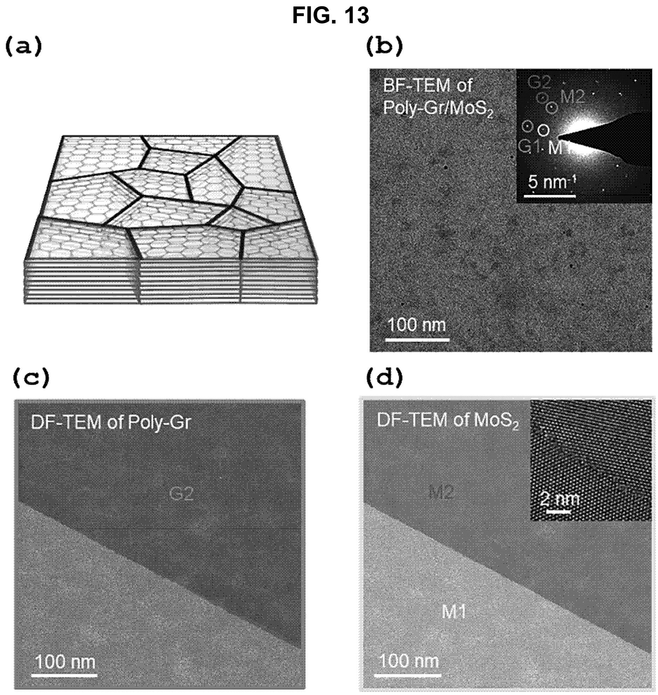

FIG. 13 shows (a) a schematic illustration of an intermediate stage of thin film formation in Example 10 using a polycrystalline graphene as a template, (b) a TEM image and diffraction pattern of the obtained MoS₂ thin film, (d) a DF-TEM image of the obtained MoS₂ thin film, and (c) a DF-TEM image of the polycrystalline graphene template.

Referring to FIG. 13, it was confirmed through the diffraction pattern that the MoS₂ patterns, M1 and M2, were aligned with the graphene patterns, G1 and G2.When comparing the DF-TEM image of the polycrystalline graphene (Poly-Gr) with the DF-TEM image of the obtained MoS₂, it was observed that the crystalline direction grains corresponding to G1 spot and the crystalline direction grains corresponding to G2 spot - distinguishable in the DF-TEM image of the polycrystalline graphene - matched the grain structures distinguishable regarding the M1 and M2 spots in the DF-TEM image of MoS₂. That is, it was clearly confirmed through the results that the lower thin film may be grown directly along the microstructure of the upper two-dimensional template.

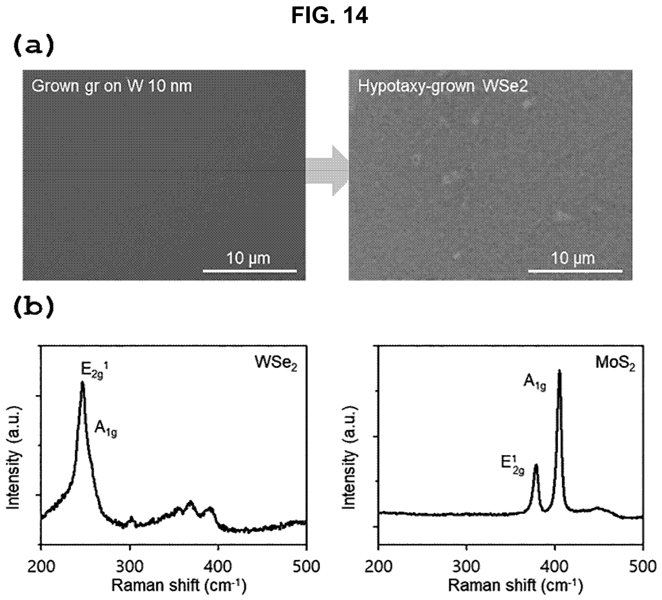

FIG. 14 shows (a) optical microscope images for the WSe₂ thin film obtained in Example 12 and the polycrystalline graphene directly grown on a tungsten substrate, and (b) a Raman spectrum for the MoS₂ and WSe₂ thin films obtained in Examples 11 and 12.

Referring to FIG. 14, it was confirmed that even when a template directly grown on the substrate was used, a thin film matching the microstructure of the template was well formed.

As a result of Experimental Example 7, it was confirmed that the single crystalline formation method according to the present disclosure may be universally applied regardless of the type of single crystalline or polycrystalline two-dimensional material used as the template.

### Example 13. Formation of MoS₂ single crystalline thin film under low temperature condition using template with pre-formed defect part

MoS₂ single crystalline thin film was formed in the same manner as in Example 1, except that before transferring the single crystalline graphene template obtained in the Manufacturing Example 1 onto the raw material thin film, hydrogen sulfide (H₂S) gas was supplied at a temperature of 1,000°C for 90 minutes at a flow rate of 20 sccm to pre-form a defect part in the template, and the reaction chamber temperature was increased to 300°C at a rate of 15°C/min.

### <Experimental Example 8. Confirmation of synthesis using template Including pre-formed defect part>

In order to confirm that formation of a crystalline thin film is possible even at low temperatures when a template with pre-formed defect part is used, TEM images and diffraction pattern analyses were performed on the MoS₂ thin film obtained in Example 13.

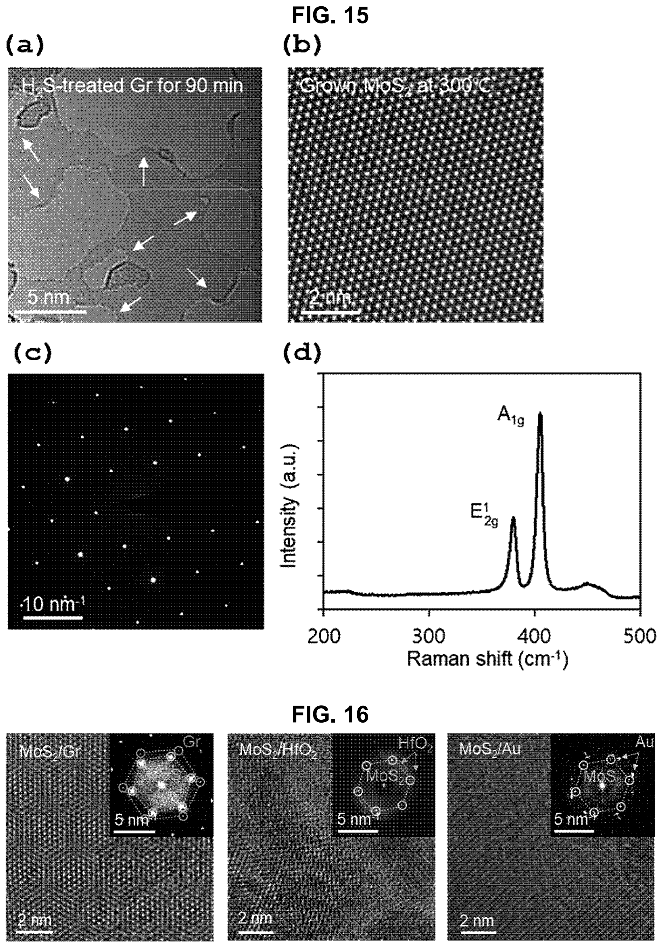

FIG. 15 shows (a) a TEM image of a template in which a defect part was formed in advance in Example 13, and (b) a TEM image, (c) a diffraction pattern, and (d) a Raman spectrum of the obtained MoS₂ single crystalline thin film.

Referring to FIG. 15, it was confirmed that a single crystalline thin film was well formed even at a reaction temperature of 300°C when using a template where a defect part was pre-formed.

### Example 14. Formation of MoS₂ single crystalline thin film on single crystalline graphene substrate

MoS₂ single crystalline thin film was formed in the same manner as in Example 1, except that, instead of a silicon substrate on which an oxide film (thickness: 285 nm) was formed, a single crystalline graphene was used as a substrate, and before transferring the single crystalline graphene template obtained in Manufacturing Example 1 onto a raw material thin film, an O₂ plasma treatment device (Femto CUTE) was used to perform O₂ plasma treatment at a power of 60 W under an O₂ 20 sccm atmosphere to pre-form a defect part in the template, and the reaction chamber temperature was increased to 400°C at a rate of 15°C/min.

### Example 15. Formation of MoS₂ single crystalline thin film on hafnium oxide (HfO₂) substrate

MoS₂ single crystalline thin film was formed in the same manner as in Example 1, except that, instead of a silicon substrate on which an oxide film (thickness: 285 nm) was formed, hafnium oxide (HfO₂), which is an insulating material and has a mixed amorphous phase and polycrystalline phase, was used as a substrate, and before transferring the single crystalline graphene template onto the raw material thin film, an O₂ plasma treatment device (Femto CUTE) was used to perform O₂ plasma treatment at a power of 60 W under an O₂ 20 sccm atmosphere, to pre-form a defect part in the template, and the reaction chamber temperature was increased to 400°C at a rate of 15°C/min.

### Example 16. Formation of MoS₂ single crystalline thin film on gold (Au) substrate

MoS₂ single crystalline thin film was formed in the same manner as in Example 1, except that, instead of a silicon substrate on which an oxide film (thickness: 285 nm) was formed, polycrystalline metal gold (Au) was used as a substrate, and before transferring the single crystalline graphene template onto the raw material thin film, an O₂ plasma treatment device (Femto CUTE) was used to perform O₂ plasma treatment at a power of 60 W under an O₂ 20 sccm atmosphere, to pre-form a defect part in the template, and the reaction chamber temperature was increased to 400°C at a rate of 15°C/min.

### <Experimental Example 9. Confirmation of thin film according to the type of lower substrate>

In order to confirm that the formation of the desired crystalline thin film is possible regardless of material and crystal structure of the lower substrate, analyses of TEM images and diffraction patterns were performed on each of the MoS₂ thin films obtained in Examples 14 to 16.

FIG. 16 shows a TEM image and a diffraction pattern for each of the MoS₂ thin films obtained in Examples 14 to 16.

Referring to FIG. 16, the MoS₂ thin film obtained in Example 14 has a single crystallinity that does not match the crystal direction of graphene which is the substrate, suggesting that the crystal structure of the formed thin film is due to the template. In addition, it was confirmed that the MoS₂ thin films obtained in Examples 15 and 16, which used hafnium oxide (HfO₂), which is an insulating material and has a mixed amorphous phase and polycrystalline phase, as a substrate or polycrystalline metal gold (Au) as a substrate, also had a single crystalline structure derived from the single crystalline graphene template regardless of the substrate.

### <Experimental Example 10. Analysis of thermal properties of thin films>

In order to analyze the thermal properties of one layer of single crystalline MoS₂ obtained in Example 1, the thermal conductivity in the vertical/horizontal directions was measured using the time-domain thermoreflectance (TDTR) method.

Specifically, an aluminum (Al) thin film that acts as a thermometer was deposited on top of the material to be measured, and the reflectivity change was measured. Then, the surface temperature could be observed in the time domain using the linear relationship between the temperature change and the aluminum reflectivity. Therefore, for this measurement, aluminum with a thickness of about 80 nm was deposited on one layer of single crystalline MoS₂ obtained in Example 1 using a DC sputter.

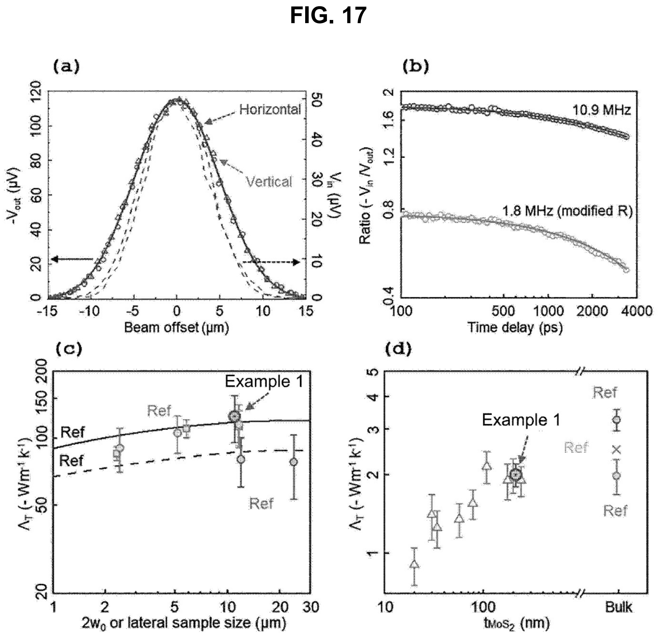

FIG. 17 shows the horizontal and vertical thermal characteristics of the MoS₂ thin film obtained in Example 1.

In the case of the vertical direction thermal conductivity, the change in thermal reflectivity (ΔR(t) = Ratio) according to the difference in the arrival times of the two beams to the specimen under the condition that the pump and probe are completely overlapped, was measured on a time scale of 4 ns, and this was compared with the change in thermal reflectivity calculated through heat transfer modeling based on the properties of the material constituting the specimen structure and measurement conditions, to derive the vertical direction thermal conductivity. The modulation frequency (f) of the pump was measured at two conditions of 10.9 MHz and 1.8 MHz, and the heat penetration depth (dp = √(Λ/πCf), Λ: vertical direction thermal conductivity, C: volumetric heat capacity, f: modulation frequency) was adjusted to independently separate and derive the vertical direction thermal conductivity.

In the case of the horizontal direction thermal conductivity, the pump and probe were spatially separated while scanning was performed, and the TDTR signal in the form of a Gaussian distribution was measured according to the distance between the two beams. The measured full width at half maximum (FWHM) of the Gaussian distribution was derived and compared with the FWHM calculated through heat transfer modeling to derive the horizontal direction thermal conductivity. The spot size was measured in advance using the in-phase signal under the absolutely dominant conditions of f = 10.9 MHz, t = +100 ps for the spot size (w₀) of the 1/e² radius used in the measurement (solid line in the graph of part (a) in FIG. 17), and the FWHM for the out-of-phase signal was derived under the dominant conditions of f = 1.8 MHz, t = - 100 ps for the measurement sensitivity for the horizontal direction radius.

As a result of the measurement, the vertical and horizontal direction thermal conductivities of one layer of the single crystalline MoS₂ thin film obtained in Example 1 were measured as (1.8±0.2) Wm⁻¹K⁻¹ and (130±30) Wm⁻¹K⁻¹, respectively.

In the case of vertical direction thermal conductivity, it is consistent with the research results of MoS₂ flakes exfoliated by considering the thickness dependence of MoS₂ thin films (FIG. 17 (d)), and in the case of horizontal direction thermal conductivity, the thermal conductivity range derived by error propagation according to measurement and specimen conditions is sufficiently consistent with the results of previous studies (FIG. 17 (c)). Based on the thermal conductivity derived using TDTR, it was confirmed that the MoS₂ thin film grown by the hypotaxy method according to the present disclosure in Example 1 exhibited excellent thermal characteristics identical to those of a single crystal.

### <Experimental Example 11. Electrical performance analysis of thin film>

In order to analyze the electrical performance of one layer of the single crystalline MoS₂ thin film obtained in Example 1, the thin film was used as a channel of a field-effect transistor (FET) array to test the electrical performance.

Specifically, one layer of the single crystalline MoS₂ thin film obtained in Example 1 was patterned using electron beam lithography, and then a MoS₂ channel region was formed using reactive ion etching (RIE), and then patterned again using electron beam lithography, and then aluminum (Al)/chromium (Cr)/gold (Au) were deposited as source and drain electrodes using an e-beam evaporator, respectively, to manufacture a total of 77 devices. Back-gate FET devices were implemented using the lower silicon as the gate and the silicon oxide layer as the insulating layer.

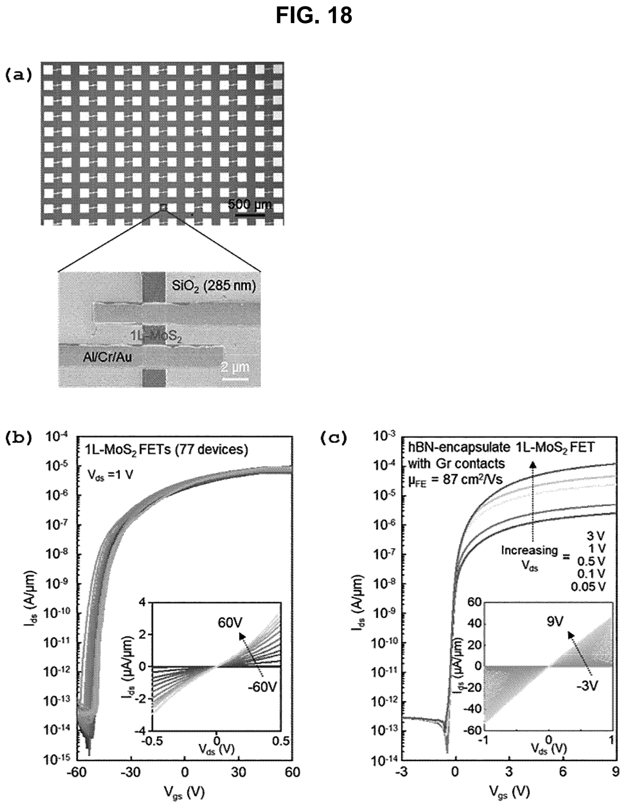

FIG. 18 shows (a) an optical microscope and SEM image, (b) a transfer curve (or output curve), and (c) a transfer curve (or output curve) as a function of drain voltage of a field effect transistor (FET) device array manufactured using the MoS₂ thin film obtained in Example 1 as a channel.

Referring to FIG. 18, 77 out of 77 manufactured devices operated and showed high yields, and also showed similar performances, indicating that the performances were implemented uniformly. In addition, compared to existing exfoliated MoS₂ single crystalline flakes or synthesized MoS₂, it showed a much better on/off current ratio, specifically, an on/off current ratio of 10⁹ or more, and a charge mobility of about 35-40 cm²/Vs and a maximum value of 79 cm²/Vs. Through this, it was confirmed that the quality of the MoS₂ thin film manufactured by the method according to the present disclosure actually showed excellent electrical performance.

Although the present disclosure has been described above by limited embodiments, the present disclosure is not limited thereto, and it is of course possible for those skilled in the art to make various modifications and variations within the scope of the technical idea of the present disclosure and the equivalent scope of the patent claims to be described below.

## Claims

1. A method for forming a crystalline thin film, the method comprising:
forming a raw material thin film on a substrate;
forming a template comprising a crystalline two-dimensional material on an upper portion of the raw material thin film; and
crystallizing the raw material thin film by heating the raw material thin film where the template is formed under an inert gas atmosphere to form a crystalline thin film,
wherein the crystalline thin film is formed by hypotaxy growth from a lower portion of the template.

2. The method according to claim 1,
wherein the crystalline two-dimensional material comprises graphene, hexagonal boron nitride (hBN), a transition metal chalcogen compound, graphene oxide, a two-dimensional oxide, black phosphorus, phosphorene, or a combination thereof.

3. The method according to claim 1,
wherein the template comprises a single crystalline two-dimensional material, and the crystalline thin film is a single crystalline thin film aligned along a crystal orientation of the single crystalline two-dimensional material.

4. The method according to claim 1,
wherein the template comprises a polycrystalline two-dimensional material, and the crystalline thin film is a polycrystalline thin film having the same microstructure along the microstructure of the polycrystalline two-dimensional material.

5. The method according to claim 1,
wherein the template is either directly grown on the raw material thin film or transferred onto the raw material thin film.

6. The method according to claim 1,
wherein the step of forming the crystalline thin film is performed at a temperature of 300°C to 1,000°C.

7. The method according to claim 1,
wherein the step of forming the crystalline thin film is performed while supplying a reactive gas.

8. The method according to claim 7,
wherein the template has a defect part formed therein.

9. The method according to claim 8,
wherein the defect part is formed during or before the step of forming the crystalline thin film.

10. The method according to claim 7,
wherein the raw material thin film comprises a transition metal,
the reactive gas is a gas comprising a chalcogen element, and
the crystalline thin film comprises a transition metal chalcogen compound.

11. The method according to claim 7,
wherein the raw material thin film comprises a transition metal,
the reactive gas is a gas comprising an oxygen element, and
the crystalline thin film comprises a transition metal oxide.
